# EUROPEAN PATENT SPECIFICATION

(11) **EP 0 563 504 B1**
(45) Date of publication and mention of the grant of the patent: **10.12.1997**
(21) Application number: 92830158.9
(22) Date of filing: 02.04.1992
(51) Int. Cl.: H01L 27/06, H01L 29/73, H01L 21/331

(54) **Integrated current-limiter device for power MOS transistors and process for the manufacture of said device**
Integrierte Strombegrenzungsanordnung für MOS-Leistungstransistoren und Verfahren zu ihrer Herstellung
Dispositif intégré limitateur de courant pour des transistors de puissance MOS et son procédé de fabrication

(43) Date of publication of application: 06.10.1993
(73) Proprietor: CONSORZIO PER LA RICERCA SULLA MICROELETTRONICA NEL MEZZOGIORNO, 95121 Catania (IT)
(72) Inventor: Zambrano, Raffaele, I-95037 San Giovanni La Punta (IT)
(74) Representative: Mittler, Enrico

(56) References cited:
- EP-A- 0 481 153
- DE-A- 3 821 065
- US-A- 4 669 177
- MATERIALS SCIENCE AND ENGINEERING B vol. B2, no. 1-3, February 1989, LAUSANNE CH pages 15-19 J.MIDDELHOEK" High Energy Implantated Transistor Fabrication
- NEUES AUS DER TECHNIK no. 3, 15 August 1986, WURZBURG DE page 1 'Lateraler Hochspannungstransistor'

## Description

The present invention relates to an integrated current-limiter device for power MOS transistors and a process for the manufacture of said device.

A current limiter for an MOS power transistor can be accomplished through the use of an MOS current-sensing transistor connected in parallel with the power transistor and in series with a sensing resistance. The voltage produced across this resistance drives the base of a bipolar control transistor so as to cause its firing, and thus the limiting of the gate voltage of the sensing and power transistors, when the voltage across the resistance and thus the current flowing through the sensing and power transistors exceeds a pre-set threshold.

A known monolithic integrated embodiment of that current limiter provides for the formation of MOS transistors of the vertical type with the drain coincident with a semi-conductor substrate of a first type of conductivity with a superimposed epitaxial layer of the same type of conductivity, but less highly doped, and of a bipolar transistor of the lateral type in a surface area of said epitaxial layer.

More precisely, inside said epitaxial layer there is a base region of the second type of conductivity, inside which there are highly-doped regions of emitter and collector of the first type of conductivity.

This integrated embodiment of the current limiter has the drawback that with the lateral bipolar transistor there is associated a vertical bipolar parasite transistor with base regions and emitter coincident with those of the lateral bipolar transistor and a collector region coincident with the substrate and thus with the drains of the MOS transistors. The maximum operating voltage of the device is thus determined by the breakdown voltage of the vertical bipolar parasite transistor, rather than by the breakdown voltage of the power MOS transistor.

DE-A-3821065 discloses a current limiting bipolar transistor comprising a base region extending to the top surface of the epitaxial layer between the emitter and collector.

The object of the present invention is to provide an integrated current-limiter device of said type and a corresponding process of its manufacture, wherein the effects of the vertical bipolar parasite transistor are reduced to a minimum while the conduction of the lateral bipolar transistor is fostered in the presence of a base bias.

According to the invention such object is attained with an integrated current-limiter device as defined in claim 1.

According to the invention there is also provided for a process of the manufacture of said current-limiter device, which includes the sucession of steps of claim 6.

There is thus obtained a lateral bipolar control transistor for a current-limiter device for an MOS power transistor, wherein the emitter region is completely enclosed by the deep-body region and by the intermediately-doped region; it is thus possible to reduce to a minimum the gain of the associated vertical bipolar parasite transistor. Such gain is further reduced thanks to the alignment between the intermediately-doped region and the first portion of the layer of polysilicon, whose connection to the collector contact determines the reversal of the conductivity of the body region in the proximity of the collector region and thus fosters the conduction of the lateral bipolar transistor, conduction that takes place only in the presence of a direct bias of the base-emitter junction. The reduction of the gain corresponds to the increase in the breakdown voltage of the vertical bipolar parasite transistor, and thus the maximum voltage at which the device can operate is no longer limited by this parasite component, but by the breakdown voltage of the power MOS transistor.

These and other features of the present invention shall be made more clear by the following detailed description of its embodiments illustrated, as a non-limiting example, in the enclosed drawings, wherein:
Fig. 1 shows a first integrated structure for a bipolar control transistor for a current-limiter device for a power MOS transistor;
Fig.s 2-7 indicate different steps for the manufacture of the bipolar control transistor of Fig. 1;
Fig. 8 shows a second integrated structure for a bipolar control transistor.

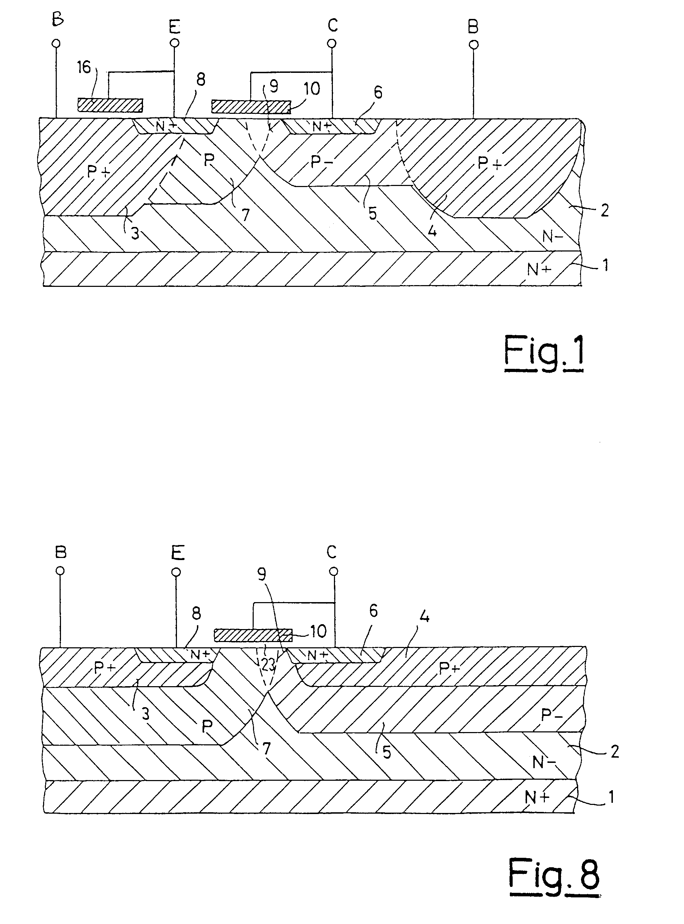

With reference to Fig. 1, a first integrated structure for a bipolar control transistor for a current-limiter device for a power MOS transistor comprises a semi-conductor substrate 1 of the type N+ over which there is superimposed an epitaxial layer 2 of the type N-. Inside the epitaxial layer 2 there is a base region, that is formed by a first and a second deep-body region 3, 4 of the type P⁺, a body region 5 of the type P⁻ that contains a collector region 6 of the type N⁺, and an intermediately-doped region 7 between the deep-body regions 3, 4 and the body region 5. Such intermediately-doped region 7, together with the first deep-body region 3, completely contains an emitter region 8 of the type N⁺.

Between the emitter region 8 and that of the collector 6 there is defined a surface area 9, that lies below, with the interposition of gate oxide (not shown), a first portion 10 of a layer of polysilicon, that is connected to the collector contact C connected to the collector region 6.

Over the deep-body region 3, again with the interposition of gate oxide, there is superimposed a second portion 16 of said layer of polysilicon, that is connected to an emitter contact E connected to the emitter region 8.

There are also base contacts B connected to the deep-body regions 3, 4.

Due to its embodiment in the form of an integrated device, the bipolar control transistor is associated with a vertical bipolar parasite transistor with base and emitter coincident with those of the control transistor and collector coincident with the substrate 1.

The fact of enclosing the emitter region 8 inside the unit formed by the deep-body region 3 and by the intermediately-doped region 7 allows the gain of the associated vertical bipolar parasite transistor to be reduced to a minimum. On the contrary, the presence of the first portion 10 of the layer of polysilicon, whose connection to the collector contact C determines the reversal of the polarity of the surface area 9, fosters the conduction (and thus the gain) of the lateral bipolar transistor should a base bias be present.

The presence of the second portion 16 of the layer of polysilicon, connected to the emitter contact E, contributes to avoiding the reversal of the polarity in the absence of base bias and increases the strength of the device.

The deep-body region 4 has the functions of a channel stop and can in turn be used as base contact.

Fig s from 2 to 7 illustrate successive steps of a process for the manufacture of the integrated structure of Fig. 1.

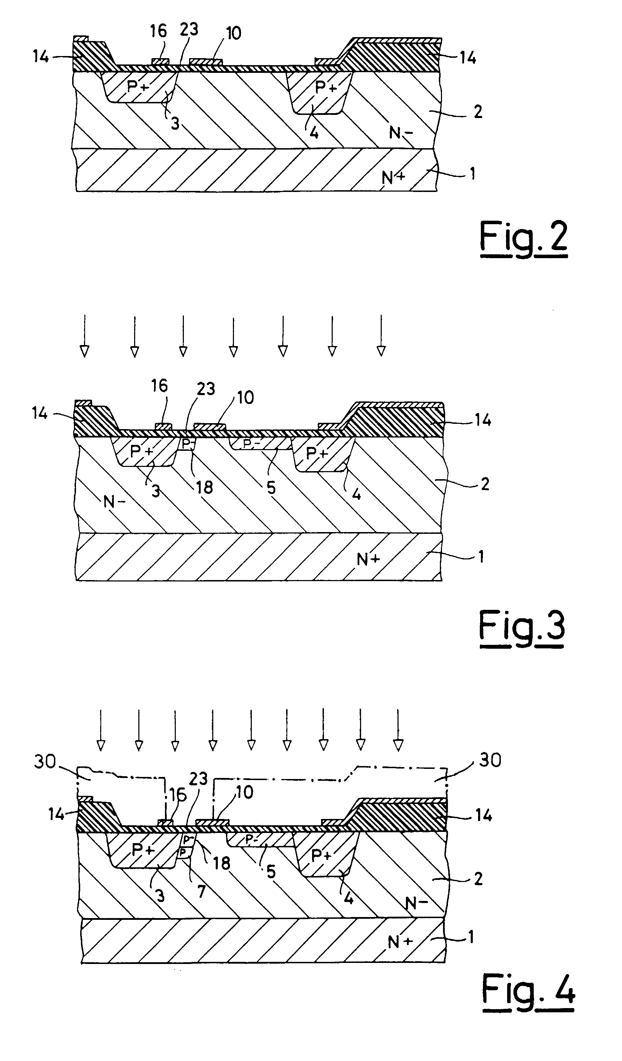

With reference to Fig. 2, the process provides for the formation of field oxide 14 on an epitaxial layer 2 of the type N⁻ grown on a substrate 1 of the type N⁺. It then provides for the definition and the implantation of a first and of a second deep-body region 3, 4 of the type P⁺ followed by the definition of active areas of the substrate by means of the selective removal of the field oxide, by the growth of a thin layer of gate oxide 23 and by the deposition and doping of a layer of polysilicon. This is then followed by the definition of a first portion 10 of this layer between the deep-body regions 3, 4, and of a second portion 16 of the same layer of polysilicon on the deep-body region 3.

With reference to Fig. 3, the process then provides for the implantation of body regions 5, 18 with B⁺ ions, self-aligned with the portions 10 and 16 of the layer of polysilicon.

With reference to Fig. 4, the process also provides for the definition, by means of an appropriate resist 30, and the implantation of an intermediately-doped region 7 of the type P, which is self-aligned with the portion 10 of the layer of polysilicon and is between the deep-body region 3 and the body region 5.

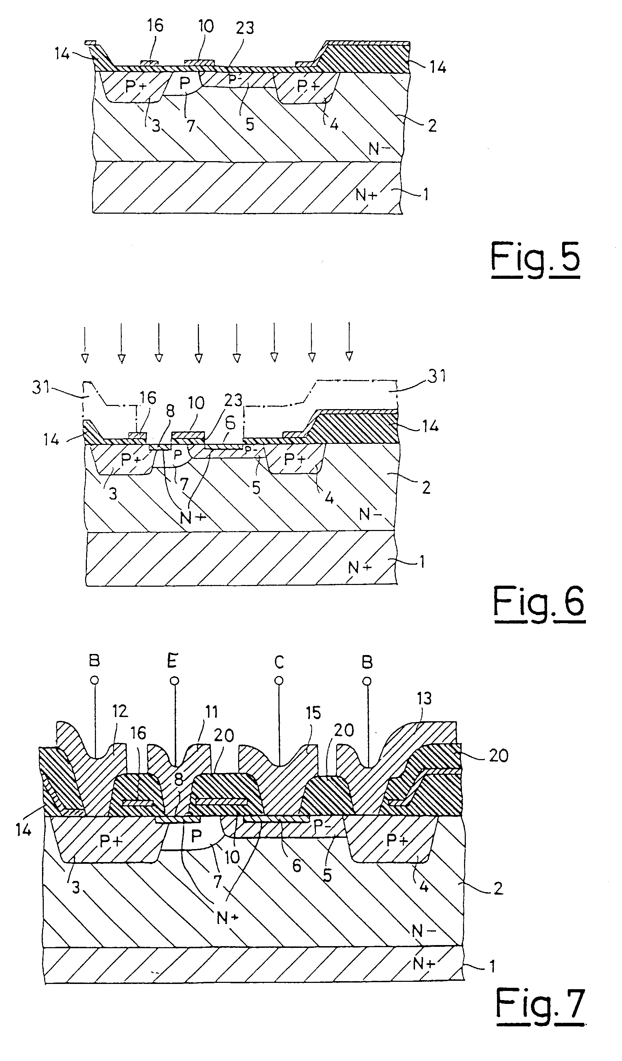

With reference to Fig. 5, the process continues with the diffusion of the body regions 5 and 18 and of the region 7.

Due to the higher doping, the region 7 diffuses to a greater depth with respect to the region 18 and thus the latter, for reasons of intelligibility, is no longer indicated in Fig.s 5, 6, 7, and in Fig.s 1 and 8.

With reference to Fig. 6, the process then provides for the definition, by means of resist 31, and the implantation of regions of collector 6 and of emitter 8 of the type N⁺. The collector region 6 is contained inside the body region 5, the emitter region 8 is contained in the deep-body region 3 and in the intermediately-doped region 7.

With reference to Fig. 7, the process comes to an end with the deposition of oxide 20 and the creation of base contacts 12, 13 for the deep-body regions 3, 4, of emitter contacts 11 for the emitter region 8 and of collector contacts 15 for the collector region 6. Contact areas for the portions 10 and 16 of the layer of polysilicon are not shown in Fig. 7, but are in any case defined in order to allow the connection to the contact areas 15 and 11, respectively.

The operation of the lateral bipolar transistor and that of the device as a whole are not jeopardized by the absence of the second portion 16 of the layer of polysilicon.

A second structure alternative to that of Fig. 1 is represented in Fig. 8. It differs from that of Fig. 1 due to the fact that the second portion 16 of the layer of polysilicon is not defined, and the deep-body regions 3 and 4 are self-aligned with the portion 10 of the layer of polysilicon, according to the process described in EP-A-0481153.

In this way the effects of the bipolar parasite transistor are further reduced.

It is also possible to provide for the definition of active areas of the device by means of LOGOS-type processes, according to techniques known to the practitioners of the art, without, on the other hand, going outside the scope of the invention as defined in the following claims.

## Claims

1. Integrated current-limiter device with bipolar control transistor for power MOS transistors, comprising:
a semiconductor substrate (1) of a first type of conductivity;
an epitaxial layer (2) of said first type of conductivity, arranged on said substrate (1) and having a top surface;
a base region (3, 4, 5, 7) of a second type of conductivity, contained in said epitaxial layer (2);
a collector region (6) and an emitter region (8), both of the first type of conductivity, contained in said base region (3, 4, 5, 7) and extending to the top surface; and
base (B), collector (C) and emitter (E) contacts electrically connected to said base (3, 4, 5, 7), collector (6) and emitter (8) regions respectively;
said base region (3, 4, 5, 7) comprising a lightly-doped base region (5), an intermediately-doped base region (7) and a highly-doped base region (3), wherein said highly-doped base region is laterally separated from said lightly-doped base region by said intermediately-doped base region;
said lightly-doped region (5) containing said collector region (6); wherein
said intermediately-doped region (7) and said highly-doped region (3) contact with each other to surround said emitter region (8); such that said emitter region is contained in said intermediately-doped base region and said highly-doped base region;
said collector and emitter regions (6, 8) are laterally spaced from each other by a portion of said lightly-doped base region extending to the top surface and by a portion of said intermediately-doped base region extending to the top surface between said emitter region and said lightly-doped base region to define a top surface area (9) between said collector and emitter regions; and wherein a polysilicon layer (10) on gate oxide electrically connected to the collector contact (C) is provided above said top surface area and capacitively coupled through the gate oxide to said top surface area (9) between the collector and emitter regions (6, 8).

2. Integrated device according to claim 1, characterized in that said base region (3, 4, 5, 7) comprises a further highly-doped base region (4) arranged at one side of the lightly-doped region (5) opposite to said top surface area (9) to act as a channel stop.

3. Integrated device according to claim 1, characterized in that said base region (3, 4, 5, 7) comprises first and second highly-doped base regions (3, 4) contained within said intermediately-doped region (7) and said lightly-doped region (5), respectively, and aligned with said polysilicon layer (10).

4. Integrated device according to claim 1, characterized in that said emitter and collector regions (8, 6) are aligned with said polysilicon layer (10).

5. Integrated device according to claim 1, characterized in that a further polysilicon layer (16) electrically connected to the emitter contact (E) is provided above and capacitively coupled through a gate oxide to said highly-doped region (3) at one side thereof opposite to said top surface area (9).

6. Process of manufacturing a current-limiter device according to claim 1 comprising the following succession of steps:
growing a lightly-doped epitaxial layer (2) of a first type of conductivity on a highly-doped substrate (1) of said first type of conductivity;
forming field oxide (14) on said epitaxial layer (2);
implanting a highly-doped base region (3) of a second type of conductivity in the epitaxial layer (2);
defining active areas of the epitaxial layer (2) by selective removal of the field oxide (14);
growing a gate oxide (23);
depositing and doping a polysilicon layer;
defining a portion (10) of said polysilicon layer at one side of said highly-doped base region (3);
implanting a lightly-doped base region (5) of said second type of conductivity, laterally spaced from said highly-doped base region (3) at said one side thereof, and
implanting an intermediately-doped base region (7) of said second type of conductivity between said highly-doped base region (3) and said lightly-doped base region (5) self-aligned with said portion of said polysilicon layer, and diffusing the base regions;
implanting highly-doped collector (6) and emitter (8) regions of the first type of conductivity inside said lightly-doped base region (5) and inside said highly-doped and intermediately-doped regions (3, 7), respectively, said collector and emitter regions having facing sides aligned with respective sides of said portion (10) of said polysilicon layer;
providing base, emitter and collector contacts (12, 11, 15) for said highly-doped base region (3), said emitter region (8) and said collector region (6), respectively; and
providing electrical connection between said portion (10) of said polysilicon layer and said collector contact (15).

7. Process according to claim 6, characterized in that a further highly-doped base region (4) of a second type of conductivity is implanted in the epitaxial layer (2) simultaneously with and laterally spaced from said highly-doped base region (3).

8. Process according to claim 6, characterized in that a further portion (16) of polysilicon layer is defined above said highly-doped base region (3) and aligned with the opposite side of said emitter region (8) simultaneously with the said portion (10) of said polysilicon layer.

## Patentansprüche

1. Integrierte Strombegrenzungsvorrichtung mit bipolarem Steuertransistor für MOS-Leistungstransistoren, die aufweist, ein Halbleitersubstrat (1) eines ersten Leitungstyps; eine Epitaxieschicht des ersten Leitungstyps, die auf dem Substrat (1) angeordnet ist und eine obere Oberfläche aufweist;
einen Basisbereich (3, 4, 5, 7) eines zweiten Leitungstyps, der in der Epitaxieschicht (2) enthalten ist;
einen Kollektorbereich (6) und einen Emitterbereich (8), beide vom ersten Leitungstyp, die in dem Basisbereich (3, 4, 5, 7) enthalten sind und sich zu der oberen Oberfläche erstrecken; und
Basis- (B), Kollektor- (C) und Emitter- (E) Kontakte, die elektrisch mit dem Basis- (3, 4, 5, 7), Kollektor- (6) bzw. Emitter- (8) Bereich verbunden sind;
wobei der Basisbereich (3, 4, 5, 7) einen leicht-dotierten Basisbereich (5), einen mittel-dotierten Basisbereich (7), und einen hoch-dotierten Basisbereich (3) aufweist, bei dem der hoch-dotierte Basisbereich lateral von dem leicht-dotierten Basisbereich duch den mittel-dotierten Basisbereich getrennt ist;
wobei der leicht-dotierte Bereich (5) den Kollektorbereich (6) enthält; bei der
der mittel-dotierte Bereich (7) und der hoch-dotierte Bereich (3) miteinander zum Umgeben des Emitterbereichs (8) kontaktieren, so daß der Emitterbereich in dem mittel-dotierten Basisbereich und dem hoch-dotierten Basisbereich enthalten ist;
die Kollektor- und Emitterbereiche (6, 8) lateral voneinander durch einen Abschnitt des leicht-dotierten Basisbereichs, der sich zu der oberen Oberfläche erstreckt, und durch einen Abschnitt des mittel-dotierten Basisbereichs, der sich zu der oberen Oberfläche zwischen dem Emitterbereich und dem leichdotierten Basisbereich erstreckt, getrennt sind, um einen oberen Oberflächenbereich (9) zwischen den Kollektor- und Emitterbereichen zu definieren; und bei der eine Polysiliziumschicht (10) auf Gateoxid, die elektrisch mit dem Kollektorkontakt (C) verbunden ist, über dem oberen Oberflächenbereich vorgesehen und kapazitiv durch das Gateoxid mit dem oberen Oberflächenbereich (9) zwischen den Kollektor- und Emitterbereichen (6, 8) gekoppelt ist.

2. Integrierte Vorrichtung nach Anspruch 1, dadurch gekennzeichnet, daß der Basisbereich (3, 4, 5, 7) einen weiteren hoch-dotierten Basisbereich (4) aufweist, der auf einer Seite des leicht-dotierten Bereichs (5), die dem oberen Oberflächenbereich (9) entgegengesetzt ist, angeordnet ist, um als ein Kanalstopper zu dienen.

3. Integrierte Vorrichtung nach Anspruch 1, dadurch gekennzeichnet,
daß der Basisbereich (3, 4, 5, 7) erste und zweite hoch-dotierte Basisbereiche (3, 4) aufweist, die in dem mittel-dotierten Bereich (7) bzw. dem leicht-dotierten Bereich (5) enthalten sind und mit der Polysiliziumschicht (10) ausgerichtet sind.

4. Integrierte Vorrichtung nach Anspruch 1,
dadurch gekennzeichnet,
daß die Emitter- und Kollektorbereiche (8, 6) mit der Polysiliziumschicht (10) ausgerichtet sind.

5. Integrierte Vorrichtung nach Anspruch 1,
dadurch gekennzeichnet,
daß eine weitere Polysiliziumschicht (16), die elektrisch mit dem Emitterkontakt (E) verbunden ist, über dem und durch ein Gateoxid kapazitiv gekoppelt mit dem hoch-dotierten Bereich (3) an einer Seite desselben, die dem oberen Oberflächenbereich (9) gegenüberliegt, vorgesehen ist.

6. Verfahren zur Herstellung einer Strombegrenzervorrichtung nach Anspruch 1, das die folgende Abfolge von Schritten aufweist:
Aufwachsen einer leicht-dotierten Epitaxieschicht (2) eines ersten Leitungstyps auf einem hoch-dotierten Substrat (1) des ersten Leitungstyps;
Ausbilden eines Feldoxids (14) auf der Epitaxieschicht (2); Implantieren eines hoch-dotierten Basisbereichs (3) eines zweiten Leitungstyps in der Epitaxieschicht (2);
Definieren von aktiven Bereichen in der Epitaxieschicht (2) durch selektives Entfernen des Feldoxids (14);
Aufwachsen eines Gateoxids (23);
Abscheiden und Dotieren einer Polysiliziumschicht;
Definieren eines Abschnittes (10) der Polysiliziumschicht an einer Seite des hoch-dotierten Basisbereiches (3);
Implantieren eines leicht-dotierten Basisbereichs (5) des zweiten Leitungstyps, der von dem hoch-dotierten Basisbereich (3) an der einen Seite desselben lateral getrennt ist, und Implantieren eines mittel-dotierten Basisbereichs (7) des zweiten Leitungstyps zwischem dem hoch-dotierten Basisbereich (3) und dem leicht-dotierten Basisbereich (5) selbstausgerichtet mit dem Abschnitt der Polysiliziumschicht, und Diffundieren der Basisbereiche;
Implantieren von hoch-dotierten Kollektor- (6) und Emitter-(8) Bereichen des ersten Leitungstyps innerhalb des leicht-dotierten Basisbereichs (5) bzw. innerhalb der hoch-dotierten und mittel-dotierten Bereiche (3, 7), wobei die Kollektor- und Emitterbereiche gegenüberliegende Seiten aufweisen, die mit entsprechenden Seiten des Abschnitts (10) der Polysiliziumschicht ausgerichtet sind;
Vorsehen von Basis-, Emitter- und Kollektorkontakten (12, 11, 15) für den hoch-dotierten Basisbereich (3), den Emitterbereich (8) bzw. den Kollektorbereich (6); und
Vorsehen einer elektrischen Verbindung zwischen dem Abschnitt (10) der Polysiliziumschicht und dem Kollektorkontakt (15).

7. Verfahren nach Anspruch 6, dadurch gekennzeichnet, daß ein weiterer hoch-dotierter Basisbereich (4) eines zweiten Leitungstyps in die Epitaxieschicht (2) gleichzeitig mit und lateral getrennt von dem hoch-dotierten Basisbereich (3) implantiert wird.

8. Verfahren nach Anspruch 6, dadurch gekennzeichnet, daß ein weiterer Abschnitt (16) der Polysiliziumschicht über dem hoch-dotierten Basisbereich (3) und ausgerichtet mit der gegenüberliegenden Seite des Emitterbereiches (8) gleichzeitig mit dem Abschnitt (10) der Polysiliziumschicht (10) definiert wird.

## Revendications

1. Dispositif intégré limiteur de courant à transistor de commande bipolaire pour des transistors MOS de puissance comprenant :
un substrat semiconducteur (1) d'un premier type de conductivité ;
une couche épitaxiale (2) du premier type de conductivité formée sur le substrat (1) et ayant une surface supérieure ; une région de base (3, 4, 5, 7) du second type de conductivité contenue dans la couche épitaxiale (2) ;
une région de collecteur (6) et une région d'émetteur (8) toutes deux du premier type de conductivité, contenues dans la région de base (3, 4, 5, 7) et s'étendant vers la surface supérieure ; et
des contacts de base (B), de collecteur (C) et d'émetteur (E) électriquement connectés aux régions respectives de base (3, 4, 5, 7), de collecteur (6) et d'émetteur (8) ;
la région de base (3, 4, 5, 7) comprenant une région de base faiblement dopée (5), une région de base à niveau de dopage intermédiaire (7) et une région de base fortement dopée (3), la région de base fortement dopée étant séparée latéralement de la région de base faiblement dopée par la région de base à niveau de dopage intermédiaire ;
la région faiblement dopée (5) contenant la région de collecteur (6) ;
dans lequel :
la région à niveau de dopage intermédiaire (7) et la région fortement dopée (3) sont en contact l'une avec l'autre pour entourer la région d'émetteur (8) de sorte que la région d'émetteur est contenue dans la région de base à niveau de dopage intermédiaire et la région de base fortement dopée ;
les régions de collecteur et d'émetteur (6, 8) sont latéralement espacées l'une de l'autre par une partie de la région de base faiblement dopée s'étendant vers la surface supérieure et par une partie de la région de base à niveau de dopage intermédiaire s'étendant vers la surface supérieure entre la région d'émetteur et la région de base faiblement dopée, pour définir une zone de surface supérieure (9) entre les régions de collecteur et d'émetteur ; et
une couche de silicium polycristallin (10) sur un oxyde de grille électriquement connectée au contact de collecteur (C) est prévue au-dessus de la surface supérieure et est capacitivement couplée par l'intermédiaire de l'oxyde de grille à la zone de surface supérieure (9) entre les régions de collecteur et d'émetteur (6, 8).

2. Dispositif intégré selon la revendication 1, caractérisé en ce que la région de base (3, 4, 5, 7) comprend une autre région de base fortement dopée (4) disposée d'un côté de la région faiblement dopée (5) opposée à la zone de surface supérieure (9) pour agir en tant qu'arrêt de canal.

3. Dispositif intégré selon la revendication 1, caractérisé en ce que la région de base (3, 4, 5, 7) comprend des première et seconde régions de base fortement dopées (3, 4) contenues dans la région à niveau de dopage intermédiaire (7) et la région faiblement dopée (5), respectivement, et alignées avec la couche de silicium polycristallin (10).

4. Dispositif intégré selon la revendication 1, caractérisé en ce que les régions d'émetteur et de collecteur (8, 6,) sont alignées avec la couche de silicium polycristallin (10).

5. Dispositif intégré selon la revendication 1, caractérisé en ce qu'une autre couche de silicium polycristallin (16) électriquement connectée au contact d'émetteur (E) est prévue au-dessus de la région fortement dopée (3) d'un côté de celle-ci opposé à la zone de surface supérieure (9), et lui est capacitivement couplée par l'intermédiaire d'un oxyde de grille.

6. Procédé de fabrication d'un dispositif limiteur de courant selon la revendication 1, comprenant les étapes suivantes :
faire croître une couche épitaxiale faiblement dopée (2) d'un premier type de conductivité sur un substrat fortement dopé (1) du premier type de conductivité ;
former un oxyde de champ (14) sur la couche épitaxiale (2) ;
implanter une région de base fortement dopée (3) d'un second type de conductivité dans la couche épitaxiale (2) ;
définir des zones actives de la couche épitaxiale (2) par enlèvement sélectif de l'oxyde de champ (14) ;
faire croître un oxyde de grille (23) ;
déposer et doper une couche de silicium polycristallin ;
définir une partie (10) de la couche de silicium polycristallin d'un côté de la région de base fortement dopée ;
implanter une région de base faiblement dopée (5) du second type de conductivité, latéralement espacée de la région de base fortement dopée (3) d'un côté de celle-ci ;
implanter une région de base à niveau de dopage intermédiaire (7) du second type de conductivité entre la région de base fortement dopée (3) et la région de base faiblement dopée (5), auto-alignée avec la partie de la couche de silicium polycristallin, et faire diffuser les régions de base ;
implanter des régions de collecteur (6) et d'émetteur (8) fortement dopées du premier type de conductivité à l'intérieur de la région de base faiblement dopée (5) et à l'intérieur des régions fortement dopées et à niveau de dopage intermédiaire (3, 7), respectivement, les régions de collecteur et d'émetteur ayant des côtés se faisant face alignés avec des côtés respectifs de la partie (10) de la couche de silicium polycristallin ;
former des contacts de base, d'émetteur et de collecteur (12, 11, 15) sur la région de base fortement dopée (3), la région d'émetteur (8) et la région de collecteur (6), respectivement ; et
former une connexion électrique entre la partie (10) de la couche de silicium polycristallin et le contact de collecteur (15).

7. Procédé selon la revendication 6, caractérisé en ce qu'une autre région de base fortement dopée (4) d'un second type de conductivité est implantée dans la couche épitaxiale (2) simultanément avec la région de base fortement dopée (3) et est latéralement espacée de celle-ci.

8. Procédé selon la revendication 6, caractérisé en ce qu'une autre partie (16) de la couche de silicium polycristallin est définie au-dessus de la région de base fortement dopée (3) et alignée avec le côté opposé de la région d'émetteur (8), en même temps que la partie (10) de la couche de silicium polycristallin.
